# EUROPÄISCHE PATENTSCHRIFT

(11) **EP 2 852 818 B1**
(45) Veröffentlichungstag und Bekanntmachung des Hinweises auf die Patenterteilung: **18.12.2019**
(21) Anmeldenummer: 13723411.8
(22) Anmeldetag: 13.05.2013
(51) Int. Cl.: G01D 5/20, G01B 7/004, G01D 5/22, G01V 3/10, G01R 27/26

(54) **VERFAHREN UND ANLAGE ZUR INDUKTIVEN BESTIMMUNG DER POSITION EINER MOBILEN EINHEIT**
METHOD AND INSTALLATION FOR INDUCTIVELY DETERMINING THE POSITION OF A MOBILE UNIT
PROCÉDÉ ET INSTALLATION DE TYPE INDUCTIF DE DÉTERMINATION DE LA POSITION D'UNE UNITÉ MOBILE

(30) Priorität: 22.05.2012 DE 102012010014
(43) Veröffentlichungstag der Anmeldung: 01.04.2015
(73) Patentinhaber: SEW-EURODRIVE GmbH & Co. KG, 76646 Bruchsal (DE)
(72) Erfinder: HUA, Zhidong, 76137 Karlsruhe (DE); WANJEK, Andreas, 68753 Waghaüsel (DE)
(86) Internationale Anmeldenummer: PCT/EP2013/001403
(87) Internationale Veröffentlichungsnummer: WO 2013/174483

(56) Entgegenhaltungen:
- DE-B- 1 296 395
- GB-A- 2 089 515
- US-B2- 7 654 009

## Beschreibung

Die Erfindung betrifft ein Verfahren zur Bestimmung der Position einer mobilen Einheit und eine Anlage zur Durchführung eines Verfahrens.

Es ist allgemein bekannt, dass eine mit Wechselstrom bestromte Wicklung in einer anderen Wicklung eine induzierte Spannung bewirkt, wobei die induktive Kopplung mit zunehmendem Abstand der Spulen abnimmt.

Aus der DE 12 96 395 B ist ein Messumformer bekannt, wobei ein Schlitten eine zu einer stationär angeordneten Spule bewegbar Spule aufweist.

Aus der US 7 654 009 B2 ist ein Absolutwinkelwertgeber bekannt.

Der Erfindung liegt daher die Aufgabe zugrunde, ein **Verfahren zur Bestimmung der Position einer mobilen Einheit** weiterzubilden.

Erfindungsgemäß wird die Aufgabe bei dem Verfahren nach den in Anspruch 1 und bei der Anlage nach den in Anspruch 12 angegebenen Merkmalen gelöst.

Wichtige Merkmale der Erfindung bei dem Verfahren zur Bestimmung einer Positionskoordinate einer mobilen Einheit sind, dass die Einheit eine erste Spule aufweist, wobei die mobile Einheit relativ zu einer stationär angeordneten zweiten Spule bewegbar angeordnet ist,
wobei die erste Spule zwei Teilwicklungen aufweist,
wobei die zweite Spule ebenfalls zwei Teilwicklungen aufweist,
**wobei** jeweilige induktive Kopplungsstärken einer jeweiligen Teilwicklung der ersten Spule oder der ersten Spule zu einer jeweiligen Teilwicklung der zweiten Spule oder zur zweiten Spule bestimmt werden,
wobei eine Phasenverschiebung der induzierten Wechselspannungssignale bestimmt wird,
wobei aus den Kopplungsstärken ein Positionsbereich bestimmt wird, in welchem die Phasenverschiebung eine eineindeutige Funktion der Position ist,
wobei aus der Phasenverschiebung die Position bestimmt wird.

Von Vorteil ist dabei, dass die induktive Kopplung zweier Spulen verwendet wird, um die relative Position zu bestimmen. Dabei wird aber nicht nur eine einzige induktive Kopplung bestimmt sondern auch mehrere induktive Kopplungen, die den jeweiligen Teilwicklungen der Spulen zugeordnet sind. Die Spulen weisen also eine wesentliche räumliche Ausdehnung auf. Denn die Teilwicklungen jeder Spule sind voneinander beabstandet. Somit sind den verschiedenen Kopplungen verschiedene Abstände der induktiven Übertragung zugeordnet, wobei durch die Abfolge der Messungen ein Muster, also eine Abfolge, von Kopplungsstärken, bewirkt ist. Weil die der jeweiligen Messung zugrunde liegenden jeweiligen Entfernungen verschieden sind, ist durch dieses Muster der Kopplungen ein Positionsbereich bestimmbar. Die Merkmale des Musters sind hierbei reduzierbar auf die bloßen Relationen der Kopplungsstärken zueinander. Somit genügt es bei der Signalauswertung sogar, nur zu überprüfen, ob eine jeweilige Kopplungsstärke größer ist als eine andere oder nicht.

Somit ist also eine Entfernung, insbesondere eine Positionskoordinate, bestimmbar. Für eine vollständige Positionsbestimmung innerhalb einer Ebene ist die Bestimmung zweier Positionskoordinaten notwendig. Hierzu wird also das obengenannte Verfahren mit Bestimmung eines Musters von Kopplungsstärken auch in einer zweiten Anordnung ausgeführt, die der ersten in unabhängiger Weise superpositioniert ist. Hierzu ist wiederum die baugleiche Spulenanordnung verwendet, wobei diese aber senkrecht, also 90°, verdreht zur obengenannten Spulenanordnung angeordnet ist. Somit arbeiten die beiden Systeme voneinander unbeeinflusst und es ist die Bestimmung der zweiten Positionskoordinate ermöglicht.

Bei einer vorteilhaften Ausgestaltung ist die Abhängigkeit der Phasenverschiebung von der Position als Tabelle in einem Speicher hinterlegt,
insbesondere wobei beim Bestimmen der Position aus der bestimmten Phasenverschiebung Tabellenwerte interpoliert werden. Von Vorteil ist dabei, dass in einfacher und eineindeutiger Weise eine Position bestimmbar ist. Denn innerhalb des mittels der auf das von den jeweiligen Kopplungsstärken gebildeten Musters angewendeten Mustererkennung bestimmten Positionsbereichs ist eine eineindeutige zuordenbare Position zu jeder bestimmten Phasenverschiebung auffindbar.

Bei einer vorteilhaften Ausgestaltung sind die Teilwicklungen der ersten Spule voneinander beabstandet und die Teilwicklungen der zweiten Spule sind ebenfalls voneinander beabstandet. Von Vorteil ist dabei, dass eine Entfernungsbestimmung ermöglicht ist, wobei die bestimmten induktiven Kopplungsstärken ausgewertet werden.

Bei einer vorteilhaften Ausgestaltung umschließen die Teilwicklungen jeweils denselben Flächenbetrag. Von Vorteil ist dabei, dass die Kopplungsstärken und deren Vergleich in einfacher Weise aus den induzierten Spannungsbeträgen bestimmbar sind. Denn durch die gleichartige Ausführung der aller Teilwicklungen und durch die parallele Anordnung, insbesondere in derselben Ebene, ist der jeweilige induzierte Spannungsbetrag ein Maß für die jeweilige induktive Kopplung.

Bei einer vorteilhaften Ausgestaltung weisen die Teilwicklungen entgegengesetzten Wickelsinn auf,
insbesondere wobei bei homogenem Wechselmagnetfeld in den Teilwicklungen jeder der Spulen der gleiche Betrag an induzierter Spannung auftritt und die induzierte Spannung in einer ersten Teilwicklung der jeweiligen Spule entgegengesetztes Vorzeichen zur in der anderen Teilwicklung der jeweiligen Spule induzierten Spannung. Von Vorteil ist dabei, dass der Spannungsbetrag eindeutig kennzeichnend ist für die jeweilige Kopplungsstärke.

Erfindungsgemäß ist als Phasenverschiebung die Phasendifferenz zwischen
- der Phase einer bei Kopplung einer einzigen Teilwicklung der ersten Spule mit einer einzigen Teilwicklung der zweiten Spule induzierten Wechselspannung
- und der Phase der bei Kopplung der Reihenschaltung der Teilwicklungen der ersten Spule mit der Reihenschaltung der Teilwicklungen der zweiten Spule induzierten Wechselspannung
verwendet. Von Vorteil ist dabei, dass die Teilwicklungen der ersten Spule nacheinander bestrombar sind und ebenso die in den Teilwicklungen der zweiten Spule induzierten Spannungen, insbesondere auch einzeln und danach gemeinsam, nacheinander detektierbar sind. Auf diese Weise ist auch die Phasenverschiebung zwischen zweier solcher Messungen detektierbar. Vorteiligerweise werden bei der Messung der induzierten Spannungen an der als Primärspule betriebenen ersten Spule mittels einer Schaltfolge steuerbaren Schalteranordnung die jeweiligen Teilwicklungen nacheinander mit Wechselstrom beaufschlagt. Mit einer anderen Schaltfolge wird die steuerbare Schalteranordnung der als Sekundärspule betriebenen zweiten Spule beaufschlagt, so dass die in den entsprechenden Teilwicklungen induzierten Spannungen nacheinander bestimmt werden. Mittels dieser Schaltfolgen ist dann ein Muster, also eine zeitliche Abfolge von Kopplungsstärken bestimmt. Dabei ist aber auch die Phasenlage der bei einem jeweiligen Schaltzustand der Schalter der beiden Schalteranordnungen induzierten Spannung detektierbar. Die sich daraus ergebende Phasenverschiebung der induzierten Spannungen innerhalb des Musters ist also ohne besonderen Zusatzaufwand bestimmbar.

Bei einer vorteilhaften Ausgestaltung wird die Position entlang einer Geraden bestimmt, von der die zweite Spule und/oder der Schwerpunkt der zweiten Spule beabstandet ist. Von Vorteil ist dabei, dass somit die erste Positionskoordinate in einfacher Weise bestimmbar ist und als Koordinatensystem ein orthogonales geradliniges Koordinatensystem verwendbar ist.

Bei einer vorteilhaften Ausgestaltung weist zur Bestimmung der zweidimensionalen Positionskoordinaten die mobile Einheit eine weitere Spule auf, die zur ersten Spule senkrecht, insbesondere 90°, verdreht angeordnet ist und eine ebenfalls stationär angeordnete zur zweiten Spule senkrecht, insbesondere 90°, verdreht angeordnete weitere Spule vorgesehen ist,
insbesondere wobei die in die Spulen eingespeisten Wechselspannungen dieselbe Frequenz aufweisen. Von Vorteil ist dabei, dass ein superpositioniertes System verwendbar ist, also ein ungestört überlagerbares System bei derselben Frequenz betreibbar ist. Hierzu ist die für die Bestimmung der zweiten Positionskoordinate notwendige weitere Spulenanordnung baugleich ausführbar, wobei diese allerdings um 90° innerhalb der Ebene, also mit einer zur Normalenrichtung der Ebene parallelen Drehachse, verdreht angeordnet ist. Die Spulen sind dabei alle parallel orientiert und somit ihre senkrechten Projektionen in eine zumindest eine der Spulen enthaltende Ebene gleich groß, aber nicht überlappend.

Erfindungsgemäß bilden die bestimmten Kopplungsstärken ein Muster, wobei Merkmale des Musters mit entsprechenden Merkmalen eines für einen jeweiligen Positionsbereich charakteristischen Musters verglichen werden,
insbesondere wobei die Merkmale Relationen einer erfassten Kopplungsstärke zu einer jeweils anderen erfassten Kopplungsstärke sind. Von Vorteil ist dabei, dass ein Vergleich der Spitzenwerte oder der Effektivwerte genügt, um die für den jeweiligen Positionsbereich charakteristischen Merkmale zu bestimmen.

Bei einer vorteilhaften Ausgestaltung sind die Positionsbereiche zweidimensionale Flächenabschnitte. Insbesondere ist die Position durch zwei Positionskoordinaten eines orthogonalen Koordinatensystems gekennzeichnet. Von Vorteil ist dabei, dass eine zweidimensionale Positionsbestimmung ermöglicht ist.

Bei einer vorteilhaften Ausgestaltung wird die Position in einer Ebene bestimmt, deren Normalenrichtung parallel zur Wicklungsachsrichtung der Teilwicklungen ist. Von Vorteil ist dabei, dass eine einfache Positionsbestimmung ermöglicht ist.

Bei einer vorteilhaften Ausgestaltung sind die Teilwicklungen Flachwicklungen, insbesondere im Wesentlichen planare Wicklungen. Von Vorteil ist dabei, dass einfach herstellbare Wicklungen verwendet werden.

Wichtige Merkmale bei der Anlage zur Durchführung eines vorgenannten Verfahrens sind, dass die zweite Spule am Boden oder im Boden der Anlage angeordnet ist und die erste Spule an einer mobilen Einheit angeordnet ist.

Von Vorteil ist dabei, dass die Erfindung mit einfach herstellbaren Mitteln realisierbar ist. Außerdem ist das System zur Durchführung des Verfahrens im induktiven Leistungs-Übertragungsbereich verwendbar.

Erfindungsgemäß ist die erste Spule mit einer ansteuerbaren Schalteranordnung derart verbunden,
so dass abhängig von der Schalterstellung jede der Teilwicklungen separat bestrombar ist oder die Reihenschaltung der Teilwicklungen bestrombar ist,
und/oder
die zweite Spule ist mit einer ansteuerbaren Schalteranordnung derart verbunden,
so dass abhängig von der Schalterstellung die in jeder der Teilwicklungen induzierte Wechselspannung oder die in der Reihenschaltung der Teilwicklungen induzierte Wechselspannung einem Messverstärker und/oder einer Auswerteeinheit zuführbar ist.

Von Vorteil ist dabei, dass durch die separate zeitlich aufeinander folgende Bestromung eine zeitliche Abfolge von Kopplungsstärken entsteht, also ein Muster. An den charakteristischen Merkmalen des Musters ist dann der Positionsbereich eindeutig erkennbar
Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:
In der Figur 1 ist eine schematische Ansicht der erfindungsgemäßen Anordnung gezeigt, wobei zwei gleichartig aufgebaute Spulen einen räumlichen Versatz zueinander aufweisen.

In der Figur 2 ist eine zugehörige Messfolge gezeigt.

In der Figur 3 sind die zur Messfolge nach Figur 2 zugehörigen Messwerte schematisch dargestellt.

In der Figur 4 ist die Beschaltung der Spule des Senders der stationär angeordneten Spule gezeigt.

In der Figur 5 ist der Verlauf der Phase zwischen den Teilwicklungen der Spule gezeigt.

In der Figur 6 ist eine entsprechende Anordnung zur Bestimmung des zweidimensionalen Versatzes gezeigt.

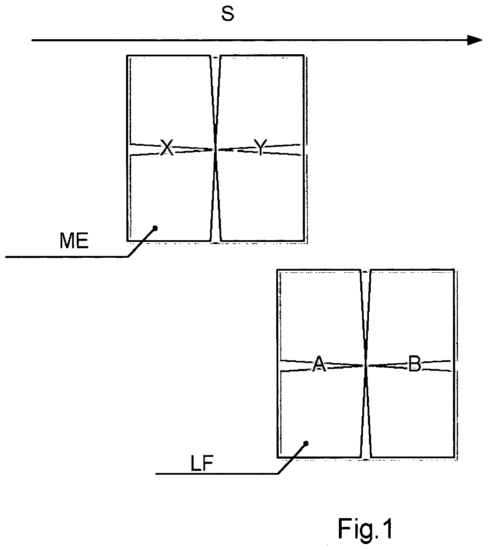

Wie in Figur 1 gezeigt, ist eine erste Spule, welche die Teilwicklungen A und B aufweist, versetzt angeordnet zu einer zweiten, auf einer mobilen Einheit angeordneten, gleichartig aufgebauten Spule, welche die Teilwicklungen X und Y aufweist.

Die zweite Spule ist in der mit Pfeilrichtung angedeuteten Richtung bewegbar angeordnet. Die Position entlang dieser Richtung ist mit S gekennzeichnet. Senkrecht zu dieser Richtung ist zwischen den Spulen ebenfalls ein nicht verschwindender Versatz vorhanden.

In der Figur 1 sind die erste und zweite Spule in dieselbe Ebene projiziert dargestellt. Zur Bestimmung des Versatzes der ersten zur zweiten Spule in der in Figur 1 gezeigten Projektions-Ebene werden die induktiven Kopplungsstärken zwischen Teilwicklungen der ersten und zweiten Spule bestimmt.

Hierzu weist die erste Spule eine Mittelanzapfung auf und die zweite Spule weist ebenfalls eine Mittelanzapfung auf. Die beiden Teilwicklungen (A, B) der ersten Spule sind somit separat betreibbar- einerseits zum Senden und andererseits zum Empfangen. Die Teilwicklung A umschließt eine Fläche, deren Betrag dem Betrag derjenigen Fläche gleicht, die von der Teilwicklung B der ersten Spule umschlossen ist. Der Wickelsinn der beiden Teilwicklungen (A, B) der ersten Spule ist zueinander entgegengesetzt. Somit wird an den beiden Teilwicklungen bei Durchflutung der ersten Spule mit einem homogenen Magnetfeld derselbe Spannungsbetrag induziert, wobei jedoch das Vorzeichen entgegengesetzt ist. Die Projektionen der Teilwicklungen (A,B) der ersten Spule in die in Figur 1 dargestellte Ebene überlappen nicht.

Ebenso weist die zweite Spule zwei Teilwicklungen (X, Y) auf, die jeweils separat betreibbar sind, da ebenfalls eine Mittelanzapfung ausgeführt ist. Die Teilwicklung X umschließt eine Fläche, deren Betrag dem Betrag derjenigen Fläche gleicht, die von der Teilwicklung Y der zweiten Spule umschlossen ist. Der Wickelsinn der beiden Teilwicklungen (X, Y) der zweiten Spule ist zueinander entgegengesetzt. Somit wird an den beiden Teilwicklungen bei Durchflutung der zweiten Spule mit einem homogenen Magnetfeld derselbe Spannungsbetrag induziert, wobei jedoch das Vorzeichen entgegengesetzt ist. Die Projektionen der Teilwicklungen (X, Y) der zweiten Spule in die in Figur 1 dargestellte Ebene überlappen nicht.

Die erste Spule und die zweite Spule sind nun in Figur 1 in der Richtung der zu bestimmenden Position beabstandet und auch in der hierzu senkrechten Richtung.

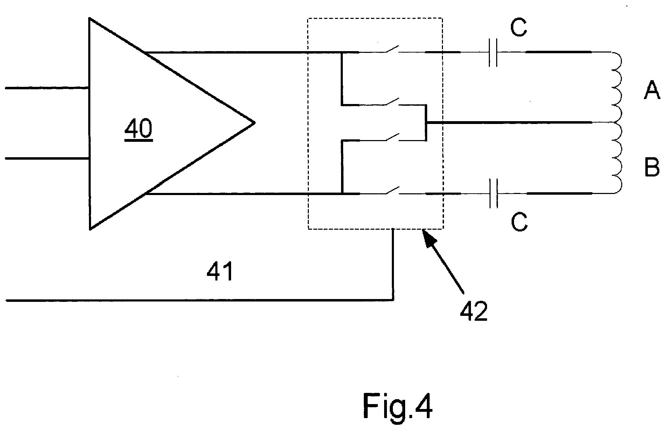

Wie in Figur 4 gezeigt, wird zum Senden ein Wechselspannungs-Signal über einen Verstärker 40 geleitet, dessen Ausgangssignal einer steuerbaren Schaltungsanordnung 42 zugeleitet, dessen Schalter steuerbar sind über Ansteuersignalleitungen 41. Somit ist je nach Schalterstellung entweder die erste Teilwicklung A oder die Teilwicklung B oder auch unter Nicht-Bestromung der Mittelanzapfung der ersten Spule beide Teilwicklungen (A+B) als Reihenschaltung das verstärkte Wechselspannungssignal zuführbar. In analoger Weise wird mit einer steuerbaren Schalteranordnung die zweite Spule verbunden, so dass die in den Teilwicklungen X und Y induzierten Spannungen separat oder auch die in die Reihenschaltung der Teilwicklungen X und Y gemeinsam induzierte Spannung einem Verstärker zuführbar sind.

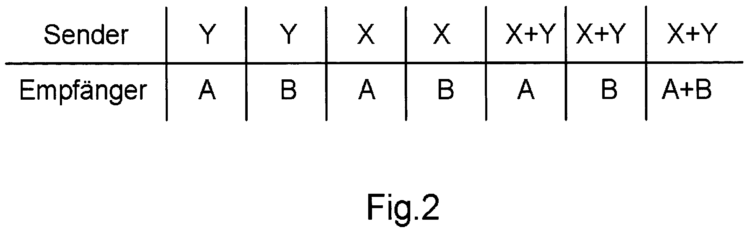

Wie in Figur 2 gezeigt, werden auf diese Weise verschiedene Kopplungen bestimmt, nämlich Teilwicklung Y mit Teilwicklung A, danach Teilwicklung Y mit Teilwicklung B, danach Teilwicklung X mit Teilwicklung A, danach Teilwicklung X mit Teilwicklung B, danach die Reihenschaltung aus Teilwicklung X und Y mit Teilwicklung A, danach die Reihenschaltung aus Teilwicklung X und Y mit Teilwicklung B, danach die Reihenschaltung aus Teilwicklung X und Y mit der Reihenschaltung aus Teilwicklung A und B.

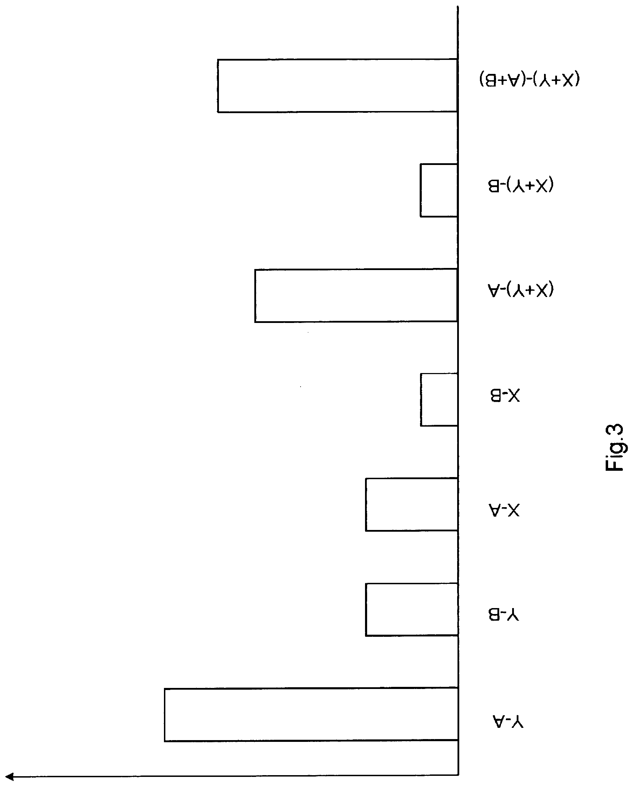

In Figur 3 sind die detektierten Kopplungsstärken für die genannten acht Kopplungen qualitativ dargestellt. Hierbei sind die Relationen der Kopplungsstärken relevant. Insgesamt bilden die Kopplungsstärken ein Muster, das einen jeweiligen Entfernungsbereich, also Positionsbereich S, kennzeichnet. Wenn beispielsweise die erste und zweite Spule denselben Positionsbereich überdecken, gleicht die Kopplungsstärke von A mit X der Kopplungsstärke B mit Y.

Somit ist also aus der Mustererkennung des jeweils bestimmten Musters an Kopplungsstärken ein Positionsbereich bestimmbar, der die Position S der mobilen Einheit umfasst.

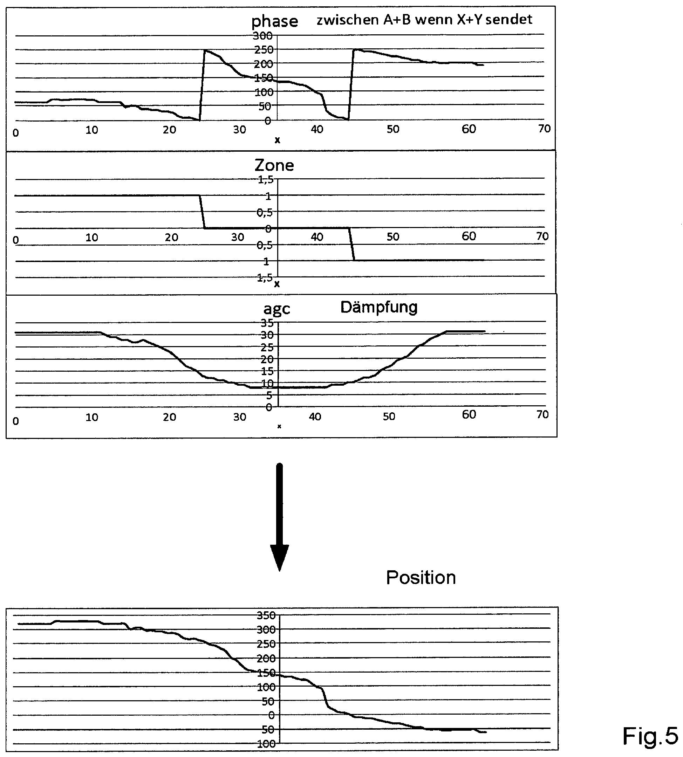

Des Weiteren wird, wie in Figur 5 gezeigt, bei Senden eines Wechselspannungssignals über die Reihenschaltung aus Teilwicklung X und Teilwicklung Y weist die in der Reihenschaltung aus Teilwicklung A und B induzierte Spannung eine Phasenverschiebung, also Phase, gegen das gesendete Wechselspannungssignal auf, welches beispielhaft als Funktion der Position S in Figur 5 dargestellt ist. Dabei ist der Verlauf der Phase im oberen Teil der Figur 5 dargestellt. Die Phase ist dabei nur innerhalb eines jeweiligen Positionsbereichs eine eineindeutige Funktion der Position S.

Da aber über die Mustererkennung ein Positionsbereich bestimmt wurde, ist eine eindeutige Bestimmung der Position S der mobilen Einheit aus der bestimmten jeweiligen Phase bestimmbar.

In Figur 5 sind noch die Positionsbereiche, also Zonen, in welchen eine eineindeutige Bestimmung der Position aus der Phase ermöglicht ist, dargestellt.

Je nach Abstand der mobilen Einheit in zur Bewegungsrichtung senkrechten Richtung sind die Positionsbereiche wiederum verschieden.

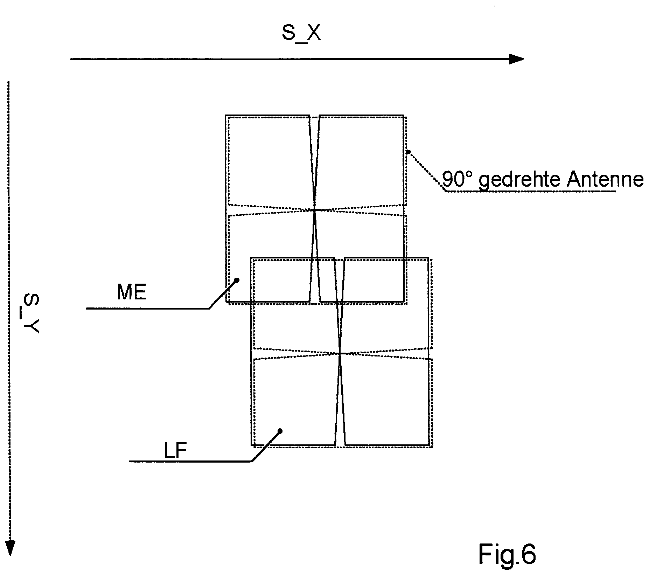

Wie in Figur 6 gezeigt, ist nicht nur eine eindimensionale Position S, also S_X, bestimmbar sondern auch die zweidimensional Position (S_X, S_Y), indem jeder der beiden Spulen eine baugleiche Spule um 90° verdreht zugeordnet wird, also eine erste stationär und eine zweite an der mobilen Einheit. Auch die Kopplungen der Teilwicklungen dieser 90° verdreht angeordneten Spulen zueinander werden bestimmt und die Phasenverschiebung bei induktiver Kopplung der Reihenschaltungen der Teilwicklungen. Somit ist auch die zur ersten Positionsrichtung S_X senkrecht gemessene Position S_Y bestimmbar.

Bei Bewegung der mobilen Einheit in Richtung der Position S wechselt das Muster der bestimmten Kopplungsstärken.

### Bezugszeichenliste

X erste Teilwicklung der Spule der mobilen Einheit
Y zweite Teilwicklung der Spule der mobilen Einheit
A erste Teilwicklung der stationär angeordneten Spule
B zweite Teilwicklung der stationär angeordneten Spule
C Kondensator
K Kopplung
agc Dämpfung
S Position
S_X Abszissen-Position
S_Y Ordinaten-Position
40 Verstärker
41 Ansteuersignalleitung
42 steuerbare Schalteranordnung

## Patentansprüche

1. Verfahren zur Bestimmung einer Positionskoordinate einer mobilen Einheit, die eine erste Spule (XY) aufweist, wobei die mobile Einheit relativ zu einer stationär angeordneten zweiten Spule (AB) bewegbar angeordnet ist, wobei die erste Spule zwei Teilwicklungen (X, Y) aufweist, wobei die zweite Spule ebenfalls zwei Teilwicklungen (A, B) aufweist, wobei die Teilwicklungen jeweils der ersten und zweiten Spule jeweils separat ansteuerbar sind durch eine jeweilige steuerbare Schalteranordnung (42), wobei zur Bestimmung der Position der ersten Spule relativ zur zweiten Spule die folgenden Verfahrensschritte ausgeführt werden:
- Bestimmung der jeweiligen induktiven Kopplungsstärken einer jeweiligen Teilwicklung (X, Y) der ersten Spule (XY) oder der ersten Spule (XY) zu einer jeweiligen Teilwicklung (A, B) der zweiten Spule (AB) oder zur zweiten Spule (AB) durch Zuführung eines Wechselspannungssignals an die Schaltungsanordnung der ersten Spule und Messen der in den Teilwicklungen der zweiten Spule induzierten Wechselspannungssignale für die entsprechende Schalterstellungen der jeweiligen Schalteranordnungen,
- Bestimmung der jeweiligen Phasen der induzierten Wechselspannungssignale für die entsprechenden Schalterstellungen,
- Bestimmung einer Phasenverschiebung zwischen der Phase einer bei Kopplung einer einzigen Teilwicklung (X, Y) der ersten Spule mit einer einzigen Teilwicklung (A, B) der zweiten Spule induzierten Wechselspannung und der Phase der bei Kopplung der Reihenschaltung der Teilwicklungen der ersten Spule mit der Reihenschaltung der Teilwicklungen der zweiten Spule induzierten Wechselspannung,
- Bildung eines Musters aus der sich durch die verschiedenen Schalterstellungen ergebenden zeitlichen Abfolge der in den jeweiligen Schalterstellungen bestimmten induktiven Kopplungsstärken,
- Bildung von Merkmalen des Musters, wobei die Merkmale Relationen einer erfassten Kopplungsstärke zu einer jeweils anderen erfassten Kopplungsstärke sind,
- Vergleich der Merkmale des gebildeten Musters mit entsprechenden Merkmalen von Mustern, die für einen jeweiligen Positionsbereich charakteristisch sind, wobei in jedem Positionsbereich die Phasenverschiebung eine eineindeutige Funktion der Position ist,
- Bestimmung des Positionsbereichs aus dem Vergleich,
- Bestimmung der Position der ersten Spule innerhalb des Positionsbereichs aus der Phasenverschiebung.

2. Verfahren nach Anspruch 1,
**dadurch gekennzeichnet, dass**
die Abhängigkeit der Phasenverschiebung von der Position als Tabelle in einem Speicher hinterlegt ist,
insbesondere wobei beim Bestimmen der Position aus der bestimmten Phasenverschiebung Tabellenwerte interpoliert werden.

3. Verfahren nach mindestens einem der vorangegangenen Ansprüche,
**dadurch gekennzeichnet, dass**
die Teilwicklungen der ersten Spule voneinander beabstandet sind und die Teilwicklungen der zweiten Spule ebenfalls voneinander beabstandet sind.

4. Verfahren nach mindestens einem der vorangegangenen Ansprüche,
**dadurch gekennzeichnet, dass**
die Teilwicklungen jeweils denselben Flächenbetrag umschließen.

5. Verfahren nach mindestens einem der vorangegangenen Ansprüche,
**dadurch gekennzeichnet, dass**
die Teilwicklungen entgegengesetzten Wickelsinn aufweisen,
insbesondere wobei bei homogenem Wechselmagnetfeld in den Teilwicklungen jeder der Spulen der gleiche Betrag an induzierter Spannung auftritt und die induzierte Spannung in einer ersten Teilwicklung der jeweiligen Spule entgegengesetztes Vorzeichen zur in der anderen Teilwicklung der jeweiligen Spule induzierten Spannung.

6. Verfahren nach mindestens einem der vorangegangenen Ansprüche,
**dadurch gekennzeichnet, dass**
die Position entlang einer Geraden bestimmt wird, von der die zweite Spule und/oder der Schwerpunkt der zweiten Spule beabstandet ist.

7. Verfahren nach mindestens einem der vorangegangenen Ansprüche, **dadurch gekennzeichnet, dass**
zur Bestimmung der zweidimensionalen Positionskoordinaten die mobile Einheit eine weitere Spule aufweist, die zur ersten Spule senkrecht, insbesondere 90°, verdreht angeordnet ist und eine ebenfalls stationär angeordnete zur zweiten Spule senkrecht, insbesondere 90°, verdreht angeordnete weitere Spule vorgesehen ist,
insbesondere wobei die in die Spulen eingespeisten Wechselspannungen dieselbe Frequenz aufweisen.

8. Verfahren nach mindestens einem der vorangegangenen Ansprüche, **dadurch gekennzeichnet, dass**
die Positionsbereiche zweidimensionale Flächenabschnitte sind.

9. Verfahren nach mindestens einem der vorangegangenen Ansprüche,
**dadurch gekennzeichnet, dass**
die Position durch zwei Positionskoordinaten eines orthogonalen Koordinatensystems gekennzeichnet ist.

10. Verfahren nach mindestens einem der vorangegangenen Ansprüche, **dadurch gekennzeichnet, dass**
die Position in einer Ebene bestimmt wird, deren Normalenrichtung parallel zur Wicklungsachsrichtung der Teilwicklungen ist.

11. Verfahren nach mindestens einem der vorangegangenen Ansprüche,
**dadurch gekennzeichnet, dass**
die Teilwicklungen Flachwicklungen, insbesondere im Wesentlichen planare Wicklungen, sind.

12. Anlage zur Durchführung eines Verfahrens nach mindestens einem der vorangegangenen Ansprüche, mit einer mobilen Einheit, die eine erste Spule (XY) aufweist und einer stationären Einheit, die eine zweite Spule (AB) aufweist wobei die mobile Einheit relative zu der stationär angeordneten Einheit bewegbar angeordnet ist, wobei die erste Spule zwei Teilwicklungen (X, Y) aufweist, wobei die zweite Spule ebenfalls zwei Teilwicklungen (A, B) aufweist, mit einer ersten und zweiten steuerbaren Schalteranordnung (42) durch welche die Teilwicklungen jeweils der ersten und zweiten Spule jeweils separat ansteuerbar sind mit:
- erstem Mittel, eingerichtet eine Bestimmung der jeweiligen induktiven Kopplungsstärken einer jeweiligen Teilwicklung der ersten Spule oder der ersten Spule zu einer jeweiligen Teilwicklung der zweiten Spule oder zur zweiten Spule durch Zuführung eines Wechselspannungssignals an die Schaltungsanordnung der ersten Spule und Messen der in den Teilwicklungen der zweiten Spule induzierten Wechselspannungssignale für die entsprechende Schalterstellungen der jeweiligen Schalteranordnungen auszuführen,
- zweitem Mittel, eingerichtet eine Bestimmung der jeweiligen Phasen der induzierten Wechselspannungssignale für die entsprechenden Schalterstellungen auszuführen,
- drittem Mittel, eingerichtet eine Bestimmung einer Phasenverschiebung zwischen der Phase einer bei Kopplung einer einzigen Teilwicklung der ersten Spule mit einer einzigen Teilwicklung der zweiten Spule induzierten Wechselspannung und der Phase der bei Kopplung der Reihenschaltung der Teilwicklungen der ersten Spule mit der Reihenschaltung der Teilwicklungen der zweiten Spule induzierten Wechselspannung auszuführen,
- viertem Mittel, eingerichtet eine Bildung eines Musters aus der sich durch die verschiedenen Schalterstellungen ergebenden zeitlichen Abfolge der in den jeweiligen Schalterstellungen bestimmten induktiven Kopplungsstärken, auszuführen,
- fünftem Mittel, eingerichtet eine Bildung von Merkmalen des Musters, wobei die Merkmale Relationen einer erfassten Kopplungsstärke zu einer jeweils anderen erfassten Kopplungsstärke sind, auszuführen,
- sechstem Mittel, eingerichtet einen Vergleich der Merkmale des gebildeten Musters mit entsprechenden Merkmalen von Mustern, die für einen jeweiligen Positionsbereich charakteristisch sind, auszuführen, wobei in jedem Positionsbereich die Phasenverschiebung eine eineindeutige Funktion der Position ist,
- siebtem Mittel, eingerichtet eine Bestimmung des Positionsbereichs aus dem Vergleich auszuführen,
- achtem Mittel, eingerichtet eine Bestimmung der Position der ersten Spule innerhalb des Positionsbereichs aus der Phasenverschiebung auszuführen,
wobei die zweite Spule am Boden oder im Boden der Anlage angeordnet ist und die erste Spule an einer mobilen Einheit angeordnet ist.

13. Anlage nach Anspruch 14, **dadurch gekennzeichnet, dass**
die erste Spule mit einer ansteuerbaren Schalteranordnung derart verbunden ist,
so dass abhängig von der Schalterstellung jede der Teilwicklungen separat bestrombar ist oder die Reihenschaltung der Teilwicklungen bestrombar ist,
und/oder dass
die zweite Spule mit einer ansteuerbaren Schalteranordnung derart verbunden ist,
so dass abhängig von der Schalterstellung die in jeder der Teilwicklungen induzierte Wechselspannung oder die in der Reihenschaltung der Teilwicklungen induzierte Wechselspannung einem Messverstärker und/oder einer Auswerteeinheit zuführbar ist.

## Claims

1. Method for determining a position coordinate of a mobile unit having a first coil (XY),
wherein the mobile unit is arranged movably relative to an immovably arranged second coil (AB),
wherein the first coil has two sub-windings (X, Y),
wherein the second coil also has two sub-windings (A, B),
wherein the respective sub-windings of the first and second coil can each be actuated separately by a respective controllable switch arrangement (42),
wherein the following method steps are carried out to determine the position of the first coil relative to the second coil:
- determining the respective inductive coupling strengths of either a particular sub-winding (X, Y) of the first coil (XY) or the first coil (XY) to either a particular sub-winding (A, B) of the second coil (AB) or the second coil (XY) by supplying an AC voltage signal to the circuit arrangement of the first coil and measuring the AC voltage signals induced in the sub-windings of the second coil for the corresponding switch positions of the respective switch arrangements,
- determining the respective phases of the induced AC voltage signals for the corresponding switch positions,
- determining a phase shift between the phase of an AC voltage induced when a single sub-winding (X, Y) of the first coil is coupled to a single sub-winding (A, B) of the second coil and the phase of the AC voltage induced when the series circuit of the sub-windings of the first coil is coupled to the series circuit of the sub-windings of the second coil,
- generating a pattern from the time sequence, resulting from the various switch positions, of the inductive coupling strengths determined in the respective switch positions,
- generating features of the pattern, wherein the features are relationships of one detected coupling strength with a different detected coupling strength,
- comparing the features of the generated pattern with corresponding features of patterns that are characteristic of a particular position range, wherein in each position range the phase shift is a biunique function of the position,
- determining the position range from the comparison,
- determining the position of the first coil within the position range from the phase shift.

2. Method according to claim 1,
**characterised in that**
the dependence of the phase shift on the position is stored in a memory as a table,
table values in particular being interpolated when determining the position from the determined phase shift.

3. Method according to at least one of the preceding claims,
**characterised in that**
the sub-windings of the first coil are spaced apart from one another and the sub-windings of the second coil are also spaced apart from one another.

4. Method according to at least one of the preceding claims,
**characterised in that**
the sub-windings each encircle the same amount of area.

5. Method according to at least one of the preceding claims,
**characterised in that**
the sub-windings have opposite winding directions,
in particular, the same amount of induced voltage occurring in the sub-windings of each of the coils when there is a homogeneous alternating magnetic field and the induced voltage in the first sub-winding of the particular coil having an opposite sign to the voltage induced in the other sub-winding of the particular coil.

6. Method according to at least one of the preceding claims,
**characterised in that**
the position is determined along a straight line from which the second coil and/or the centroid of the second coil is spaced apart.

7. Method according to at least one of the preceding claims,
**characterised in that**
to determine the two-dimensional position coordinates, the mobile unit has a further coil arranged perpendicularly, in particular rotated by 90°, to the first coil, and a further coil is provided, which is likewise immovably arranged and arranged perpendicularly, in particular rotated by 90°, to the second coil,
the AC voltages fed into the coils in particular having the same frequency.

8. Method according to at least one of the preceding claims,
**characterised in that**
the position ranges are two-dimensional area sections.

9. Method according to at least one of the preceding claims,
**characterised in that**
the position is identified by two position coordinates of an orthogonal coordinate system.

10. Method according to at least one of the preceding claims,
**characterised in that**
the position is determined in a plane of which the normal direction is parallel to the winding axis direction of the sub-windings.

11. Method according to at least one of the preceding claims,
**characterised in that**
the sub-windings are flat windings, in particular substantially planar windings.

12. Installation for carrying out a method according to at least one of the preceding claims, comprising a mobile unit, which has a first coil (XY), and an immovable unit (AB) having a second coil, wherein the mobile unit is arranged movably with respect to the immovably arranged unit,
wherein the first coil has two sub-windings (X, Y),
wherein the second coil also has two sub-windings (A, B),
comprising a first and second controllable switch arrangement (42), by which the respective sub-windings of the first and second coil can each be actuated separately,
comprising:
- first means set up to determine the respective inductive coupling strengths of either a particular sub-winding of the first coil or the first coil to either a particular sub-winding of the second coil or the second coil by supplying an AC voltage signal to the circuit arrangement of the first coil and measuring the AC voltage signals induced in the sub-windings of the second coil for the corresponding switch positions of the respective switch arrangements,
- second means set up to determine the respective phases of the induced AC voltage signals for the corresponding switch positions,
- third means set up to determine a phase shift between the phase of an AC voltage induced when a single sub-winding of the first coil is coupled to a single sub-winding of the second coil and the phase of the AC voltage induced when the series circuit of the sub-windings of the first coil is coupled to the series circuit of the sub-windings of the second coil,
- fourth means set up to generate a pattern from the time sequence, resulting from the various switch positions, of the inductive coupling strengths determined in the respective switch positions,
- fifth means set up to generate features of the pattern, wherein the features are relationships of one detected coupling strength with a different detected coupling strength,
- sixth means set up to compare the features of the generated pattern with corresponding features of patterns that are characteristic of a particular position range, wherein in each position range the phase shift is a biunique function of the position,
- seventh means set up to determine the position range from the comparison,
- eighth means set up to determine the position of the first coil within the position range from the phase shift,
wherein the second coil is arranged on the base or in the base of the installation and the first coil is arranged on a mobile unit.

13. Installation according to claim 14,
**characterised in that**
the first coil is connected to an actuatable switch arrangement such that, depending on the switch position, current can be applied to each of the sub-windings separately or current can be applied to the series circuit of the sub-windings,
and/or **in that**
the second coil is connected to an actuatable switch arrangement such that, depending on the switch position, the AC voltage induced in each of the sub-windings or the AC voltage induced in the series circuit of the sub-windings can be supplied to a measuring amplifier and/or an evaluation unit.

## Revendications

1. Procédé pour déterminer une coordonnée de position d'une unité mobile qui présente une première bobine (XY),
l'unité mobile étant disposée de manière mobile par rapport à une deuxième bobine (AB) disposée de manière stationnaire,
la première bobine présentant deux enroulements partiels (X, Y),
la deuxième bobine présentant également deux enroulements partiels (A, B),
les enroulements partiels de chacune des première et deuxième bobines pouvant être commandés séparément par un agencement de commutateurs commandable respectif (42),
les étapes suivantes étant effectuées pour déterminer la position de la première bobine par rapport à la deuxième bobine :
- détermination des intensités de couplage inductif respectives d'un enroulement partiel respectif (X, Y) de la première bobine (XY) ou de la première bobine (XY) à un enroulement partiel respectif (A, B) de la deuxième bobine (AB) ou à la deuxième bobine (AB) par amenée d'un signal de tension alternative à l'agencement de commutation de la première bobine et mesure des signaux de tension alternative induits dans les enroulements partiels de la deuxième bobine pour les positions de commutateurs correspondantes des agencements de commutateurs respectifs,
- détermination des phases respectives des signaux de tension alternative induits pour les positions de commutateurs correspondantes,
- détermination d'un déphasage entre la phase d'une tension alternative induite en cas de couplage d'un seul enroulement partiel (X, Y) de la première bobine avec un seul enroulement partiel (A, B) de la deuxième bobine et la phase de la tension alternative induite en cas de couplage du circuit série des enroulements partiels de la première bobine avec le circuit série des enroulements partiels de la deuxième bobine,
- formation d'un motif à partir de la séquence chronologique des intensités de couplage inductif déterminées dans les positions de commutateurs respectives résultant des différentes positions de commutateurs,
- formation de caractéristiques du motif, les caractéristiques étant des relations entre une intensité de couplage détectée et une autre intensité de couplage détectée respective,
- comparaison des caractéristiques du motif formé avec des caractéristiques correspondantes de motifs qui sont caractéristiques d'une plage de positions respective, le déphasage étant, dans chaque plage de positions, une fonction biunivoque de la position,
- détermination de la plage de positions à partir de la comparaison,
- détermination de la position de la première bobine dans la plage de positions à partir du déphasage.

2. Procédé selon la revendication 1,
**caractérisé en ce que**
la dépendance du déphasage de la position est enregistrée sous forme de table dans une mémoire,
en particulier dans lequel des valeurs de table sont interpolées lors de la détermination de la position à partir du déphasage déterminé.

3. Procédé selon au moins l'une des revendications précédentes,
**caractérisé en ce que**
les enroulements partiels de la première bobine sont espacés les uns des autres et les enroulements partiels de la deuxième bobine sont également espacés les uns des autres.

4. Procédé selon au moins l'une des revendications précédentes,
**caractérisé en ce que**
les enroulements partiels renferment chacun la même quantité de surface.

5. Procédé selon au moins l'une des revendications précédentes,
**caractérisé en ce que**
les enroulements partiels présentent des sens d'enroulement opposés,
dans lequel, en particulier dans le cas d'un champ magnétique alternatif homogène, il apparaît la même amplitude de tension induite dans les enroulements partiels de chacune des bobines et la tension induite dans un premier enroulement partiel de la bobine respective est de signe opposé à la tension induite dans l'autre enroulement partiel de la bobine respective.

6. Procédé selon au moins l'une des revendications précédentes,
**caractérisé en ce que**
la position est déterminée le long d'une droite de laquelle la deuxième bobine et/ou le centre de gravité de la deuxième bobine est espacé(e).

7. Procédé selon au moins l'une des revendications précédentes,
**caractérisé en ce que**,
pour déterminer les coordonnées de position bidimensionnelles, l'unité mobile présente une autre bobine qui est disposée perpendiculairement, en particulier à 90°, par rapport à la première bobine, et une autre bobine qui est également disposée de manière stationnaire et disposée perpendiculairement, en particulier à 90°, par rapport à la deuxième bobine, est prévue,
en particulier dans lequel les tensions alternatives injectées dans les bobines présentent la même fréquence.

8. Procédé selon au moins l'une des revendications précédentes,
**caractérisé en ce que**
les plages de positions sont des sections de surface bidimensionnelles.

9. Procédé selon au moins l'une des revendications précédentes,
**caractérisé en ce que**
la position est **caractérisée par** deux coordonnées de position d'un système de coordonnées orthogonales.

10. Procédé selon au moins l'une des revendications précédentes,
**caractérisé en ce que**
la position est déterminée dans un plan dont la direction de la normale est parallèle à la direction de l'axe d'enroulement des enroulements partiels.

11. Procédé selon au moins l'une des revendications précédentes,
**caractérisé en ce que**
les enroulements partiels sont des enroulements plats, en particulier des enroulements sensiblement plans.

12. Installation pour mettre en œuvre un procédé selon au moins l'une des revendications précédentes,
avec une unité mobile qui présente une première bobine (XY) et une unité stationnaire qui présente une deuxième bobine (AB), l'unité mobile étant disposée de manière mobile par rapport à l'unité disposée de manière stationnaire,
la première bobine présentant deux enroulements partiels (X, Y),
la deuxième bobine présentant également deux enroulements partiels (A, B),
avec un premier et un deuxième agencement de commutateurs commandables (42), au moyen desquels les enroulements partiels de chacune de la première et de la deuxième bobine peuvent être commandés séparément,
avec :
- un premier moyen conçu pour effectuer une détermination des intensités de couplage inductif respectives d'un enroulement partiel respectif de la première bobine ou de la première bobine à un enroulement partiel respectif de la deuxième bobine ou à la deuxième bobine par amenée d'un signal de tension alternative à l'agencement de commutation de la première bobine et mesure des signaux de tension alternative induits dans les enroulements partiels de la deuxième bobine pour les positions de commutateurs correspondantes des agencements de commutateurs respectifs,
- un deuxième moyen conçu pour effectuer une détermination des phases respectives des signaux de tension alternative induits pour les positions de commutateurs correspondantes,
- un troisième moyen conçu pour effectuer une détermination d'un déphasage entre la phase d'une tension alternative induite en cas de couplage d'un seul enroulement partiel de la première bobine avec un seul enroulement partiel de la deuxième bobine et la phase de la tension alternative induite en cas de couplage du circuit série des enroulements partiels de la première bobine avec le circuit série des enroulements partiels de la deuxième bobine,
- un quatrième moyen conçu pour effectuer une formation de motif à partir de la séquence chronologique des intensités de couplage inductif déterminées dans les positions de commutateurs respectives résultant des différentes positions de commutateurs,
- un cinquième moyen conçu pour effectuer une formation de caractéristiques du motif, les caractéristiques étant des relations entre une intensité de couplage détectée et une autre intensité de couplage détectée respective,
- un sixième moyen conçu pour effectuer une comparaison des caractéristiques du motif formé avec des caractéristiques correspondantes de motifs qui sont caractéristiques d'une plage de positions respective, le déphasage étant, dans chaque plage de positions, une fonction biunivoque de la position,
- un septième moyen conçu pour effectuer une détermination de la plage de positions à partir de la comparaison,
- un huitième moyen conçu pour effectuer une détermination de la position de la première bobine dans la plage de positions à partir du déphasage,
la deuxième bobine étant disposée sur le sol ou dans le sol de l'installation et la première bobine étant disposée sur une unité mobile.

13. Installation selon la revendication 14,
**caractérisée en ce que**
la première bobine est reliée à un agencement de commutateurs commandable de telle sorte que, en fonction de la position des commutateurs, chacun des enroulements partiels puisse être alimenté séparément ou que le circuit série des enroulements partiels puisse être alimenté,
et/ou que
la deuxième bobine est reliée à un agencement de commutateurs commandable de telle sorte que, en fonction de la position des commutateurs, la tension alternative induite dans chacun des enroulements partiels ou la tension alternative induite dans le circuit série des enroulements partiels puisse être amenée à un amplificateur de mesure et/ou à une unité d'évaluation.
